(19) Europäisches Patentamt
European Patent Office
Office européen des brevets

(11) EP 1 980 099 B1

(12) **EUROPEAN PATENT SPECIFICATION**

(45) Date of publication and mention of the grant of the patent:
**23.03.2011 Bulletin 2011/12**

(21) Application number: **07717955.4**

(22) Date of filing: **16.01.2007**

(51) Int Cl.:
***H04N 5/44*** *(2011.01)* ***H04N 5/46*** *(2006.01)*
***H03H 7/00*** *(2006.01)*

(86) International application number:
**PCT/EP2007/000331**

(87) International publication number:
**WO 2007/080132 (19.07.2007 Gazette 2007/29)**

(54) **FILTER DEVICE**

FILTERVORRICHTUNG

DISPOSITIF DE FILTRE

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **16.01.2006 EP 06100400**

(43) Date of publication of application:
**15.10.2008 Bulletin 2008/42**

(73) Proprietor: **NXP B.V.**
**5656 AG Eindhoven (NL)**

(72) Inventor: **KATTNER, Axel**
**A-1101 Vienna (AT)**

(74) Representative: **Krott, Michel et al**
**NXP B.V.**
**Intellectual Property & Licensing Department**
**High Tech Campus 32**
**5656 AE Eindhoven (NL)**

(56) References cited:
**GB-A- 2 244 611** **US-A1- 2003 001 648**
**US-A1- 2005 220 224** **US-B1- 6 667 760**

- **KOBAYASHI H ET AL: "Explicit transfer function of RC polyphase filter for wireless transceiver analog front-end" ASIC, 2002. PROCEEDINGS. 2002 IEEE ASIA-PACIFIC CONFERENCE ON AUG. 6-8, 2002, PISCATAWAY, NJ, USA,IEEE, 6 August 2002 (2002-08-06), pages 137-140, XP010602812 ISBN: 0-7803-7363-4**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

FIELD OF THE INVENTION

The invention relates to a filter device particularly for devices for receiving television signals as well as a device for receiving television signals including a filter device.

Filter devices for devices for receiving television signals are known both for receiving analog television signals and for receiving digital television signals. With analog television signals, the transmission is achieved with a vestigial sideband modulation. This means that the sidebands are asymmetrically designed. In order to determine the baseband signal here, a Nyquist slope is therefore necessary, which brings the difference in the amplitude of the double-sideband range and of the single-sideband range into line with each other.

BACKGROUND OF THE INVENTION

In known receiving devices the Nyquist slope is realized in the IF frequency range by external, what are referred to as SAW filters, which are also called Surface Acoustic Wave filters. These SAW filters produce channel selectivity and form a Nyquist slope. Due to the multiplicity of television standards worldwide, SAW filters forming different Nyquist slopes are necessary. These SAW filters forming different Nyquist slopes differ in the bandwidth, intermediate frequency and the width of the double-sideband range.

In more recent receiving devices, according to newer concepts for receiving multi-standard television signals, a window-SAW-filter is used instead of a multiplicity of SAW filters. The external SAW filter can also be avoided by an internal selectivity. In both cases, an integration of a Nyquist slope must be realized in order to be able to realize an analog television signal reception.

Typically, a window-SAW-filter is used for receiving digital television signals.

US patent publication No. US 2003/0001648 discloses a phase shifter using a polyphase filter, which achieves a broad band, suppresses errors in both amplitude and phase, and achieves low power consumption. A driving section includes a voltage-to-current conversion circuit for converting a voltage value of an input signal Si into a current value, and outputting an input current signal Ci. An RC polyphase filter outputs a corresponding polyphase phase-shifted current signal Co according to supplying of the input current signal Ci. A load circuit includes a polyphase current-to-voltage conversion circuit for converting a current value of the polyphase phase-shifted current signal Co into a voltage value, and outputting an output signal Vo.

US 6,667,760 discloses a receiver for receiving digital television (DTV) signals with carriers near the upper frequency boundaries of TV broadcasting channels, in which a co-channel interfering NTSC video carrier and its lower frequency sidebands are removed from intermediate-frequency signal by trap filtering, preferably in SAW filtering used in the intermediate-frequency amplifier. Co-channel interfering NTSC-chroma burst and lower frequency chroma sidebands also are removed from intermediate-frequency signal by trap filtering. Artifacts of co-channel interfering NTSC audio signal in baseband DTV signal recovered by in-phase synchrodyne circuitry are cancelled using Hilbert-transformed artifacts of co-channel interfering NTSC audio signal recovered by quadrature-phase synchrodyne circuitry. Locating DTV carriers close to 270 kHz below the uppermost limits of the TV broadcasting channels facilitates artifacts arising from chroma signals, video carriers and low-frequency video modulation of co-channel interfering NTSC signals being further reduced using comb filtering.

GB 2 244 611 discloses a synchronous television receiver including an I signal block, a Q signal block, a baseband 90° phase shifter for obtaining in phase video signals from the I and Q signal blocks, an adder for adding the in phase signals, and phase equalizer for correcting phase distortion of the adder output. The 90° phase shifter has an operating frequency band including a received channel and a lower-adjacent-channel, and the receiver cancels and suppresses interference from the lower-adjacent-channel. A video signal is extracted from the phase equalizer. The receiver can also detect amplitude and phase differences of lower-adjacent-channel sound carriers including in the video signals from the and Q signal blocks, and can minimize these differences. Kobayashi H et al "Explicit transfer function of RC polyphase filter for wireless transceiver analog front-end" ASIC, 2002. PROCEEDINGS. 2002 IEEE ASIA-PACIFIC CONFERENCE ON AUG. 6-8, 2002, PISCATAWAY, NJ, USA, IEEE, 6 August 2002 (2002-08-6), pages 137-140, XP010602812 ISBN: 0-7803-7363-4 derives explicit frequency-transfer functions for first, second and third order RC polyphase filters using a concept of complex signal and circulant matrix properties.

US 2005/0220224 discloses a polyphase filter including first and second filter sections and a buffer section. The first filter section has an input for receiving signals representative of at least two phases of an input signal, and an output for providing signals representative of at least two phases of filtered signal, and has a first passband response. The buffer section has an input coupled to the output of the first filter section, and an output. The second filter section has an input coupled to the output of the buffer, and an output for providing an output of the polyphase filter, and has a second passband response. The first and second filter sections are configured such that the second passband response compensates for the first passband response.

## OBJECT AND SUMMARY OF THE INVENTION

It is an object of the invention to design a filter device for receiving a vestigial sideband modulated signal particularly for receiving television signals with a Nyquist slope, which device needs reduced expenditure regarding the integration of hybrid television reception and has a common filter for analog and digital television signal reception. The filter device should bring the amplitude of the double-sideband range into line with the amplitude of the single-sideband range at least substantially. Further, it is an object to provide a device for receiving television signals including a filter device.

The object, according to the invention, is achieved in accordance with the characteristics of claim 1 and claim 5. Advantageous further embodiments are described in the dependent claims.

Advantageously, the invention provides a filter device particularly intended for receiving television signals, which receives input signals and generates output signals, wherein the filter device forms a Nyquist slope by means of a passive polyphase filter. Thus, the device can be used with a window-SAW-filter, which is also used for receiving digital television signals.

The passive polyphase filter comprises a plurality of simple passive polyphase filter stages. The filter device may thus be used for different television standards when it is expedient for the device to have a plurality of simple passive polyphase filter stages.

The passive polyphase filter comprises a first simple passive polyphase filter stage, which is designed in such a way that each input phase ($\varphi$) is connected to the output of the same phase ($\varphi$) by means of a resistor $R_2$, furthermore, a capacitor C connects the input of a phase ($\varphi$) to the output of a subsequent phase ($\varphi + 90°$) respectively and resistor $R_1$ connects an input of a phase ($\varphi$) to the inverted output ($\varphi + 180°$) respectively.

Furthermore, it is expedient if a second simple passive polyphase filter stage is designed in such a way that each input phase ($\varphi$) is connected to the output of the same phase ($\varphi$) by means of a resistor R and furthermore, a capacitor C connects the input of a phase ($\varphi$) to the output of a subsequent phase ($\varphi + 90°$) respectively.

It may be expedient if before or after the first simple polyphase filter stage further and different polyphase filter stages are also provided if necessary. Herein, the sequence of the individual passive polyphase filter stages may be interchanged.

It is particularly advantageous that a good linearity is achieved, because no active components are needed. The Nyquist filter can also be extended to a filter for suppressing the image frequencies, in order to reduce or prevent interference from the adjacent channels.

These and other aspects of the invention are apparent from and will be elucidated with reference to the embodiments described hereinafter.

## BRIEF DESCRIPTION OF THE DRAWINGS

In the drawings:

- Fig. 1 gives a representation of an external SAW filter with a Nyquist slope for receiving analog television signals according to the state of art;
- Fig. 2 gives a representation of a window SAW filter with a Nyquist slope for receiving digital television signals,
- Fig. 3 shows a diagram with a Nyquist slope in the baseband,
- Fig. 4 gives a schematic representation of a filter device according to the invention,
- Fig. 5a gives a schematic representation of a simple passive polyphase filter stage,
- Fig. 5b shows a diagram of an amplitude response as a function of frequency,
- Fig. 6a gives a schematic representation of a simple passive polyphase filter stage,
- Fig. 6b shows a diagram of an amplitude response as a function of frequency; and
- Fig. 7 shows a diagram of an amplitude response as a function of frequency.

## DESCRIPTION OF EMBODIMENTS

Fig. 1 shows an external SAW filter with a Nyquist slope for receiving analog television signals (ATV) and Fig. 2 shows a window SAW filter for receiving digital television signals (DTV). Here, the desired channel 1, 2 below the curve 3, 4 respectively of the respective filter is selected corresponding to the transfer function of the filter. For this purpose, Fig. 3 shows a diagram with a Nyquist slope in the baseband and the demodulated television signal. In the baseband the complex demodulated television signal comprises a double-sideband range (DSB), which is symmetrical around 0 Hz and a single-sideband range (SSB), which comprises the higher video frequencies. The picture carrier is at 0 Hz after the demodulation. The Nyquist slope in the baseband functions around 0 Hz and brings the DSB signal into line with the level of the SSB signal.

The invention proposes to carry out a filtering with a Nyquist slope by means of a passive polyphase filter 10, as represented in Fig. 4. The complex demodulation produces a 4-phase signal at 0°, 90°, 180° and 270°. These four phases are supplied to the passive polyphase filter 10, which comprises one or a plurality of simple passive polyphase filter stages 11, 12, 13. Here, the stages 11, 12, 13 may comprise, for example, one of the filter stages represented in the Figs. 5a or 6a.

The simple passive polyphase filter stage according to Fig. 5a is formed in such a way that each input phase is connected to the output of the same phase by means of a resistor $R_2$. At the same time, a capacitor C connects the input of a phase (φ to the output of a subsequent phase (φ + 90°). The resistors $R_1$ connect the input of a phase (φ to the inverted output (φ + 180°) respectively.

In Fig. 5a one recognizes a total of four inputs with a 0°, 90°, 180° and 270° phase shift on the left side of the representation of the filter stage, wherein each input phase (φ) is connected to the output of the same phase (φ) represented on the right by means of a resistor $R_2$, 21, 22, 23, 24. At the same time a capacitor C connects the input of a phase (cp) to the output of a subsequent phase (φ + 90°) respectively, thus the input of the phase at 0° to the output of phase at 90° etcetera. Accordingly, it is effected that the resistors $R_1$, 25, 26, 27, 28 connect the input of a phase φ to the inverted output (φ + 180°), such as, for example, the input of the phase at 0° to the output of the phase at 180°.

The simple passive polyphase filter stage according to Fig. 5a has the following transfer function $H_1$ (p):

$$H_1(p) = \frac{pC_1 + j\left(\frac{1}{R_2} - \frac{1}{R_1}\right)}{pC_1 + \left(\frac{1}{R_2} + \frac{1}{R_1}\right)}$$

This transfer function has a zero position with the imaginary frequency $f_{01}$:

$$f_{01} = -j\frac{1}{2\pi}\frac{R_1 - R_2}{R_1R_2C_1}$$

and has a pole with the negative real frequency $f_{x1}$:

$$f_{x1} = -\frac{1}{2\pi}\frac{R_1 + R_2}{R_1R_2C_1}$$

The amplitude response IHI is represented in Fig. 5b as a function of the frequency f. The absolute value of the transfer function with frequency f=0 is:

$$|H_1(p=0)| = \frac{\frac{1}{R_2} - \frac{1}{R_1}}{\frac{1}{R_2} + \frac{1}{R_1}} = \frac{R_1 - R_2}{R_1 + R_2} = H_0$$

Fig. 6b shows a further simple passive polyphase filter stage 30, which is formed in such a way that each input (φ), in Fig. 6a on the left, is connected to the output of the same phase (φ) by means of a resistor R, 31, 32, 33, 34, in Figure 6a on the right. At the same time a capacitor C, 35, 36, 37, 38 connects the input of a phase (φ) to the output of a following phase ((φ) + 90°).

The transfer function results in:

$$H_2(p) = \frac{\frac{1}{R} - jpC}{\frac{1}{R} + pC}$$

The transfer function has a zero position with the imaginary frequency $f_{02}$:

$$f_{02} = -j\frac{1}{2\pi}\frac{1}{RC}$$

and has poles with negative real frequency $f_{x2}$:

$$f_{x2} = -\frac{1}{2\pi}\frac{1}{RC}$$

The amplitude response IHI is represented in Fig. 6b as a function of the frequency f. The absolute value of the transfer function with frequency f=0 is:

$$|H_2(p=0)| = \frac{\frac{1}{R}}{\frac{1}{R}} = 1 = 0dB$$

In order to form a Nyquist slope, a simple passive polyphase filter stage according to Fig. 5a is expedient. The zero position of this stage can be set on the negative end of the double-sideband range with $f_0$ = -1.25Hz for the television standards I and L and -0.75 MHz for the television standards M, N, B, G, D and K. Furthermore, the absolute value of the transfer function in the case f = 0 is set to ½, thus to -6 dB. Hence R1 = 3*R2 is the result.

In order to use one Nyquist slope for various television standards and manage a process variation it is suggested according to the invention that the zero position be shifted to a lower frequency particularly nearer to 0 Hz and that the higher negative frequencies of the double-sideband signal be suppressed by additional simple passive polyphase filter stages as represented in Fig. 3 in the diagram of an amplitude response as a function of the frequency.

Here, the further simple passive polyphase filter stages may be stages according to Fig. 5a or Fig. 6a. With the use of a passive polyphase filter with N stages the absolute value of the cumulative transfer function results in:

$$|H(p=0)| = H_{10} * H_{20} * \ldots * H_{N0} = ½.$$

Using a plurality of different stages allows the image frequency gain over a further frequency range and the optimization of the amplitude waviness of the passband.

Fig. 7 shows that the Nyquist slope turns at 0Hz or -6 dB respectively as a result of a process variation or a temperature fluctuation and the zero positions are dependent on the frequency. Thus the picture contents, which are more strongly amplified with negative frequencies, are more present with positive frequencies and vice versa. This means that a process variation and a possible temperature fluctuation do not have any special influence on the characteristic of the output signal.

## Claims

1. A filter device (10) particularly for receiving television signals, wherein input signals can be received and output signals can be generated, wherein the filter device forms a Nyquist slope by means of a passive polyphase filter, the device being **characterized by** a first simple passive polyphase filter stage (20) is designed in such a way that each input phase is connected to the output of the same phase by means of a resistor $R_2$ (21, 22, 23, 24), furthermore, a capacitor C connects the input of a phase to the output of a subsequent phase (φ + 90°) respectively and resistors $R_1$ (25, 26, 27, 28) connect an input of a phase φ to the inverted output (φ + 180°) respectively, and

- a second simple passive polyphase filter stage (30) is designed in such a way that each input phase is connected to the output of the same phase by means of a resistor R (31, 32, 33, 34) and furthermore, a capacitor C (35, 36, 37, 38) connects the input of a phase (φ) with the output of a following phase (φ + 90°) respectively.

**2.** A filter device as claimed in claim 1, **characterized in that** the passive polyphase filter has at least one or a multiplicity of simple passive polyphase filter stages (11, 12), which are preferably switched consecutively.

**3.** A filter device as claimed in any one of the preceding claims, **characterized in that** before or after the first simple polyphase filter stage also further and different polyphase filter stages are provided if necessary.

**4.** A filter device as claimed in any one of the preceding claims, **characterized in that** the filter device is realized as an electronic component, such as an integrated circuit.

**5.** A device for receiving television signals including a filter device as claimed in at least one of the preceding claims 1 to 4.

**Patentansprüche**

**1.** Filtervorrichtung (10), insbesondere zum Empfangen von Fernsehsignalen, wobei Inputsignale empfangen werden können und Outputsignale erzeugt werden können, wobei die Filtervorrichtung mittels eines passiven Polyphasenfilter einen Nyquistslope bildet, wobei die Vorrichtung **dadurch** charakterisiert ist, dass
eine erste simple passive Polyphasenfilterstufe (20) in einer solchen Weise eingerichtet ist, dass jede Inputphase mittels eines Widerstandes $R_2$ (21, 22, 23, 24) mit dem Output derselben Phase verbunden ist, ferner verbindet eine Kapazität C den Input einer Phase mit dem Output einer jeweils nachfolgenden Phase (φ+90°) und Widerstände $R_1$ (25, 26, 27, 28) verbinden einen Input einer Phase φ mit dem jeweils invertierten Output (φ+180°), und
eine zweite simple passive Polyphasenfilterstufe (30) in einer solchen Weise eingerichtet ist, dass jede Inputphase mittels eines Widerstandes R (31, 32, 33, 34) mit dem Output derselben Phase verbunden ist, und ferner dass eine Kapazität C (35, 36, 37, 38) den Input einer Phase (φ) mit dem Output einer jeweils folgenden Phase (φ+90°) verbindet.

**2.** Filtervorrichtung gemäß Anspruch 1, **dadurch gekennzeichnet, dass** der passive Polyphasenfilter zumindest eine oder eine Mehrzahl von simplen passiven Polyfilterstufen (11, 12) aufweist, welche vorzugsweise nacheinander geschaltet werden.

**3.** Filtervorrichtung gemäß irgendeinen der vorstehenden Ansprüche, **dadurch gekennzeichnet, dass**, wenn nötig, vor oder nach der ersten simplen Polyphasenfilterstufe auch weitere und andere Polyphasenfilterstufen bereitgestellt sind.

**4.** Filtervorrichtung gemäß irgendeinen der vorstehenden Ansprüche, **dadurch gekennzeichnet, dass** die Filtervorrichtung als eine elektronische Komponente verwirklicht ist, wie beispielsweise einem integrierten Schaltkreis.

**5.** Vorrichtung zum Empfangen von Fernsehsignalen, welche eine Filtervorrichtung gemäß zumindest einem der vorstehenden Ansprüche 1 bis 4 aufweist.

**Revendications**

**1.** Dispositif de filtrage (10) particulièrement destiné à la réception de signaux de télévision, dans lequel on peut recevoir des signaux d'entrée et générer des signaux de sortie, dans lequel le dispositif de filtrage forme une pente de Nyquist à l'aide d'un filtre passif polyphasé, le dispositif étant **caractérisé par le fait qu'**un premier étage de filtrage passif polyphasé simple (20) est conçu de telle manière que chaque phase d'entrée est raccordée à la sortie de la même phase à l'aide d'une résistance $R_2$ (21, 22, 23, 24), qu'en outre, un condensateur C raccorde l'entrée d'une phase à la sortie d'une phase suivante (φ + 90°) respectivement et que des résistances $R_1$ (25, 26, 27, 28) raccordent une entrée d'une phase φ à la sortie inversée (φ + 180°) respectivement, et

- qu'un deuxième étage de filtrage passif polyphasé simple (30) est conçu de telle manière que chaque phase d'entrée est raccordée à la sortie de la même phase à l'aide d'une résistance R (31, 32, 33, 34) et qu'en outre, un condensateur C (35, 36, 37, 38) raccorde l'entrée d'une phase (φ) à la sortie d'une phase suivante (φ + 90°) respectivement.

**2.** Dispositif de filtrage selon la revendication 1, **caractérisé par le fait que** le filtre passif polyphasé a au moins un ou une multiplicité d'étages de filtre passif polyphasé simple (11, 12) qui sont de préférence commutés consécutivement.

**3.** Dispositif de filtrage selon l'une quelconque des revendications précédentes, **caractérisé par le fait qu'**avant ou après le premier étage de filtre passif polyphasé simple sont disposés, si nécessaire, d'autres étages de filtre polyphasé différents.

**4.** Dispositif de filtrage selon l'une quelconque des revendications précédentes, **caractérisé par le fait que** le dispositif de filtrage est réalisé sous la forme d'un composant électronique, comme un circuit intégré.

**5.** Dispositif pour recevoir des signaux de télévision comprenant un dispositif de filtrage selon l'une quelconque des revendications 1 à 4.

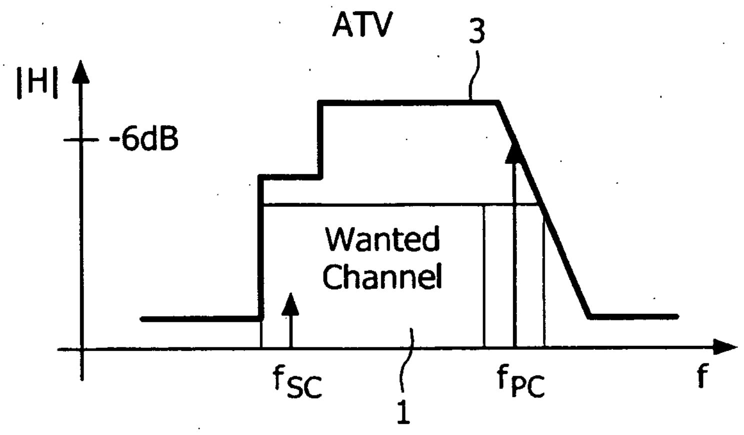


FIG. 1

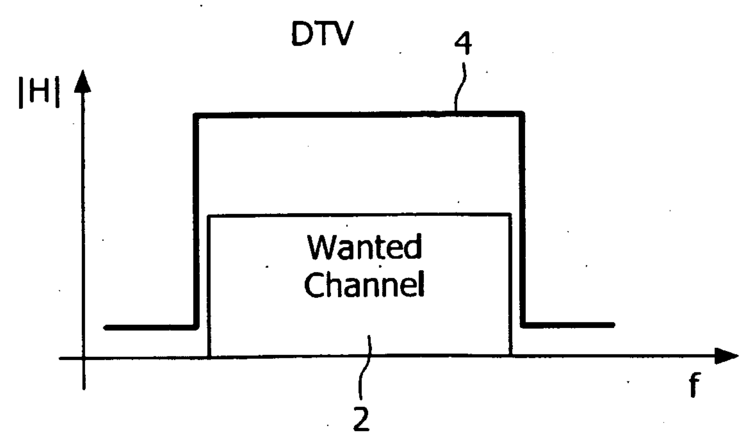


FIG. 2

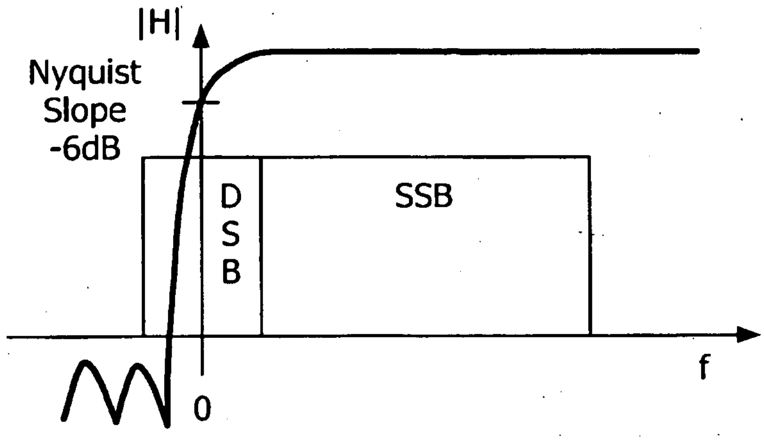


FIG. 3

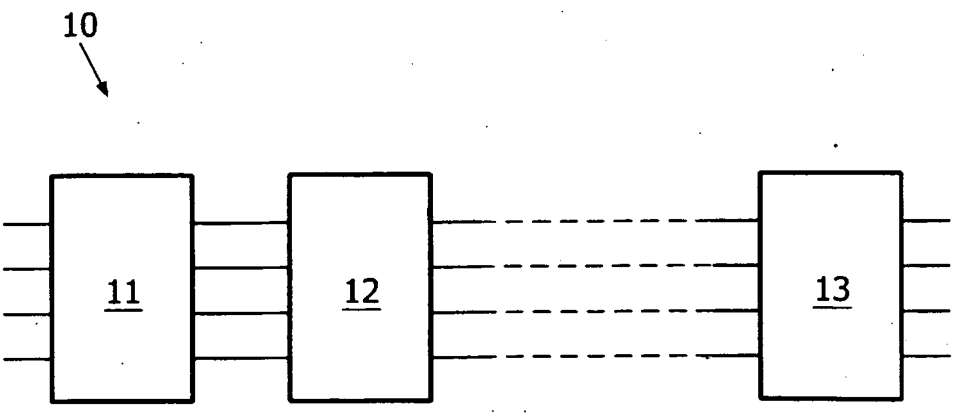


FIG. 4

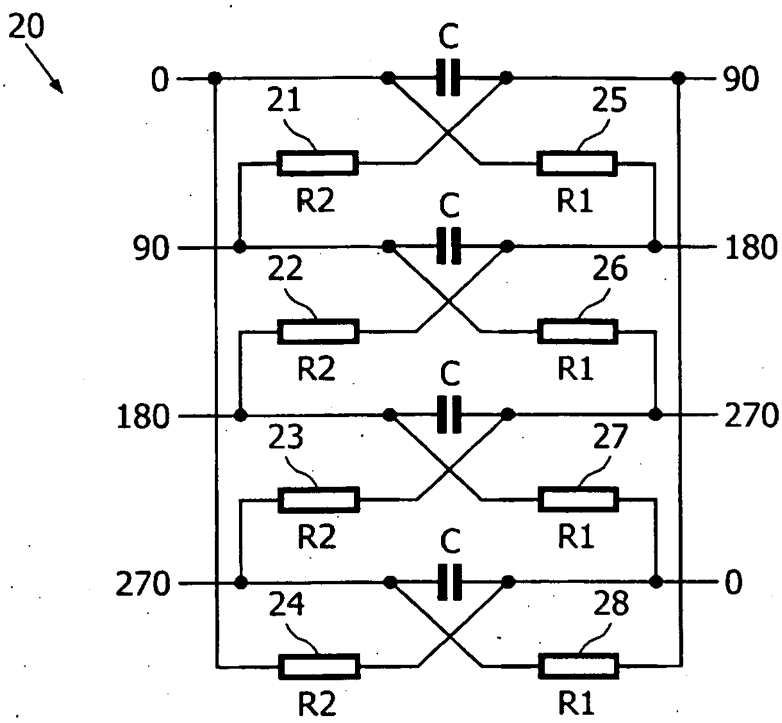


FIG. 5a

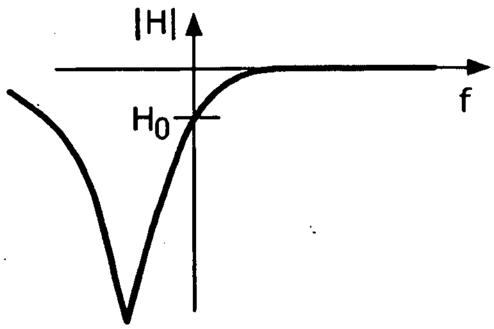


FIG. 5b

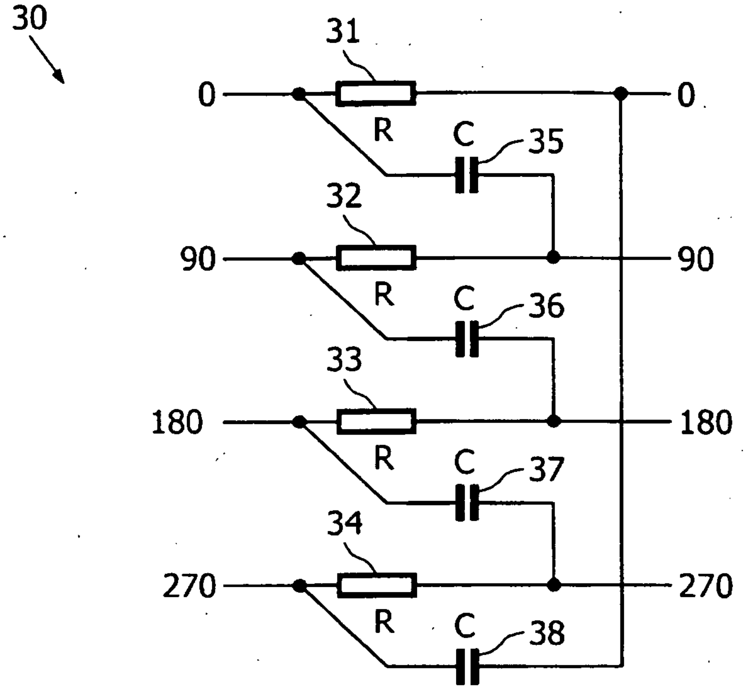


FIG. 6a

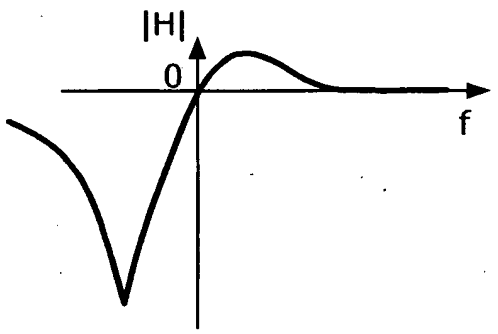


FIG. 6b

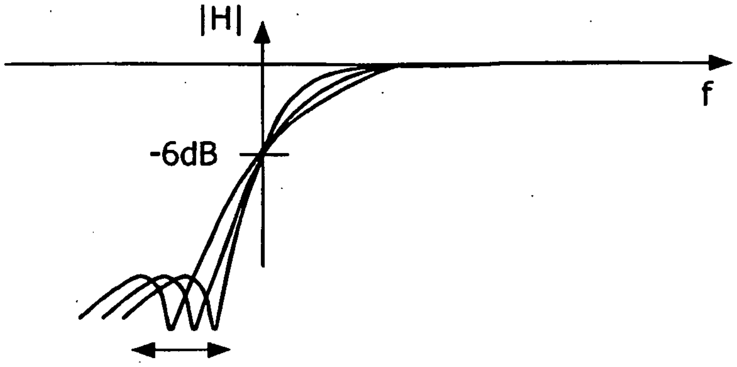


FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20030001648 A
- US 6667760 B
- GB 2244611 A
- US 20050220224 A

### Non-patent literature cited in the description

- **Kobayashi H et al.** Explicit transfer function of RC polyphase filter for wireless transceiver analog front-end. *ASIC, 2002. PROCEEDINGS. 2002 IEEE ASIA-PACIFIC CONFERENCE ON AUG. 6-8, 2002,* 06 August 2002, ISBN 0-7803-7363-4, 137-140